# EUROPÄISCHE PATENTSCHRIFT

(11) **EP 1 378 929 B1**
(45) Veröffentlichungstag und Bekanntmachung des Hinweises auf die Patenterteilung: **05.01.2005**
(21) Anmeldenummer: 03014915.7
(22) Anmeldetag: 01.07.2003
(51) Int. Cl.: H01J 37/32

(54) **Kühlung für Plasmareaktor**
Cooling for plasma reactor
Refroidissement d'un réacteur à plasma

(30) Priorität: 04.07.2002 DE 20210328 U
(43) Veröffentlichungstag der Anmeldung: 07.01.2004
(73) Patentinhaber: Strämke, Siegfried, Dr., 52499 Baesweiler (DE)
(72) Erfinder: Strämke, Siegfried, Dr., 52499 Baesweiler (DE)
(74) Vertreter: Selting, Günther, Dipl.-Ing.

(56) Entgegenhaltungen:
- DE-A- 10 105 427
- US-A- 4 361 749
- US-A- 4 471 003
- US-A- 5 846 375
- US-A1- 2002 023 589
- PATENT ABSTRACTS OF JAPAN vol. 1995, no. 11, 26. Dezember 1995 (1995-12-26) & JP 07 220895 A (II C KAGAKU KK;OTHERS: 02), 18. August 1995 (1995-08-18)
- PATENT ABSTRACTS OF JAPAN vol. 017, no. 579 (E-1451), 21. Oktober 1993 (1993-10-21) & JP 05 175160 A (TOKYO OHKA KOGYO CO LTD), 13. Juli 1993 (1993-07-13)

## Beschreibung

Die Erfindung betrifft einen Plasmareaktor mit einem mit einer Vakuumpumpe verbindbaren vakuumdichten Behälter, der einen Arbeitsraum zur Aufnahme von Werkstücken enthält, einer Spannungsquelle zum Anlegen einer Spannung an das Werkstück und einer in dem Behälter angeordneten Kühlvorrichtung zum Abführen von Strahlungswärme von dem Werkstück.

Bei Plasmaprozessen, bei denen ein Werkstück einer Plasmabehandlung wie Plasmanitrieren, Plasmaaufkohlen oder Plasmabeschichten unterzogen wird, wird über die elektrische Entladung die an der Oberfläche des Werkstücks erfolgt, Energie in den Behälter eingebracht. Im stationären Fall erfolgt eine Abführung der Energie über Wand, Deckel und Boden des Behälters durch Strahlung. Ist diese Energieabfuhr nicht ausreichend, kann eine Kühlvorrichtung in den Behälter eingebaut werden. Eine solche Kühlvorrichtung besteht üblicherweise aus Kühlfingern in Form wassergekühlter Zylinder. Derartige Kühlfinger bilden punktuelle Sümpfe für die Wärmestrahlung, wobei ungleiche Temperaturverteilungen im Arbeitsraum des Behälters auftreten können. In der Regel ist es nur für einen definierten Chargenaufbau möglich, die Kühlfinger so anzuordnen, dass der gewünschte Wärmehaushalt hergestellt wird. Ein weiterer Nachteil von Kühlfingern besteht darin, dass an der kalten Oberfläche Kondenswasser entsteht. Ferner besteht das Problem, dass die Enden der Charge grundsätzlich zu kalt sind, da über den Deckel und den Boden zusätzlich Wärme abgeführt wird.

In US 5,846,375 ist ein Temperatursteuersystem zur selektiven Steuerung der Temperatur in verschiedenen Zonen einer Werkstückplattform beschrieben, wobei die Werkstückplattform in einem Vakuumbehälter zur Behandlung von Halbleiterwaver angeordnet ist. Die Werkstückplattform enthält mehrere koaxial verlaufende ringförmige Kanäle, die an separate Kühlquellen angeschlossen sind. Dadurch können unterschiedliche Behandlungsbereiche unterschiedlich stark gekühlt werden.

US 2002/0023589 A1 beschreibt einen Plasmareaktor mit einem Entladungsrohr, das koaxial beabstandete Kühlbereiche aufweist, die jeweils an eine Zuführleitung und eine Rückführleitung für ein Kühlfluid angeschlossen sind. Auf diese Weise können unterschiedliche Bereiche des Entladungsrohres mit verschiedenen Intensitäten gekühlt werden.

Der Erfindung liegt die Aufgabe zugrunde, einen Plasmareaktor mit verbesserter Kühlvorrichtung zu schaffen, bei dem eine gleichmäßige Kühlung des Werkstücks ohne die Gefahr der örtlichen Überhitzung oder Unterkühlung erfolgt.

Die Lösung dieser Aufgabe geschieht erfindungsgemäß mit den im Anspruch 1 angegebenen Merkmalen. Hiernach besteht die Kühlvorrichtung aus mindestens zwei ungeregelten Kühlelementen, die Ein- und Ausschaltbar sind. Die Kühlelemente sind Kühlschlangen, deren Windungen miteinander verschachtelt sind und die einzeln ein- und ausschaltbar sind.

Dadurch, dass die Kühlelemente im Binärbetrieb einzeln ein- und ausgeschaltet werden, ist eine einfache Dosierung der Kühlleistung möglich. Die Erfindung geht von dem Gedanken aus, dass die Wärmeenergie, die durch Wärmestrahlung von dem Werkstück auf die Kühlelemente übertragen wird, von der vierten Potenz der Temperatur der Kühlelemente abhängig ist. Folglich wirkt sich eine Ein- und Ausschaltung viel effektiver auf die Veränderung der Kühllast aus, als eine kontinuierliche Regelung. Die Kühlelemente sind so geschaltet, dass eine stufenweise Veränderung der Kühlleistung erfolgt.

Die Kühlelemente sind in abwechselnder Folge angeordnet. Sie bilden somit eine Verschachtelungs- oder Wechselstruktur, bei der benachbarte Kühlelemente zwar unterschiedliche Temperaturen haben, die Kühlleistung sich aber über eine größere Fläche gleichmäßig verteilt. Dies ist eine Wirkung, die der Wirkung von schwarzen und weißen Pixeln in einem Graubild vergleichbar ist. Bei Betrachtung aus größerer Entfernung verwischen sich die einzelnen Pixel zu Grautönen. Die Erfindung verzichtet auf eine Regelung der Kühlmitteltemperatur und sieht eine Ein- und Abschaltung verschachtelt angeordneter Kühlelemente vor.

Die Kühlvorrichtung kann den Arbeitsraum außen umgeben oder auch im Innern des Arbeitsraumes angeordnet sein. Zweckmäßigerweise erstreckt sie sich nur über den mittleren Bereich der Höhe des Arbeitsraumes und lässt die Enden frei, weil an den Enden ohnehin eine verstärkte Wärmeabstrahlung durch das Gehäuse erfolgt.

Vorzugsweise sind die Kühlelemente als Kühlschlangen ausgebildet, die schraubenförmig gewickelt sind, wobei die Windungen mehrerer Kühlelemente sich gegenseitig abwechseln. Die Windungen sollten gegenseitige Abstände haben, um die Gasströmung nicht zu behindern. Eine Gasströmung findet nach Beendigung der Plasmabehandlung in der Abkühlphase statt.

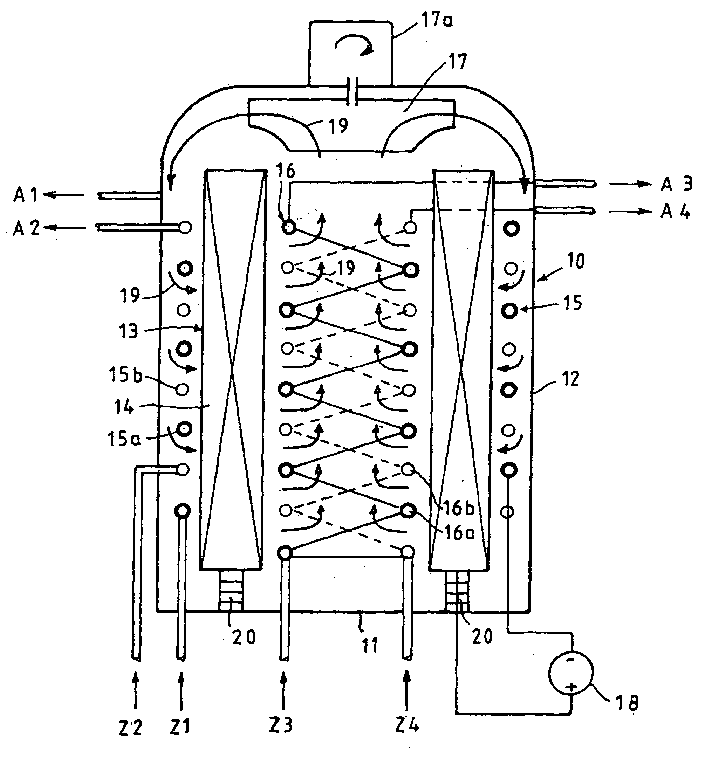

Im folgenden wird unter Bezugnahme auf die einzige Figur der Zeichnung ein Ausführungsbeispiel der Erfindung näher erläutert.

In der Zeichnung ist ein Längsschnitt durch einen Plasmareaktor schematisch dargestellt.

Der Plasmareaktor ist hier als Haubenofen ausgebildet. Er weist einen Behälter 10 mit einem Boden 11 und einer abnehmbaren Haube 12. Der Behälter 10 ist vakuumdicht. Er enthält den Arbeitsraum 13, in dem eine Charge aus zu behandelnden Werkstücken 14 angeordnet wird. Bei dem vorliegenden Ausführungsbeispiel ist der Arbeitsraum 13 ringförmig. Die Werkstücke 14 ruhen auf Isolatoren 20 auf dem Boden 11. In der Haube 12 befindet sich ein Radialgebläse 17 mit einem Motor 17a.

Das Werkstück 14 ist an einen Pol der Spannungsquelle 18 angeschlossen. Der andere Pol der Spannungsquelle ist mit der Masse des Behälters 10 verbunden. Der Behälter 10 ist an eine (nicht dargestellte) Vakuumquelle anschließbar, um im Behälter ein Vakuum zu erzeugen. Ferner kann der Behälter an eine oder mehrere Gasquellen angeschlossen werden, um ein Arbeitsgas oder ein Inertgas in den Behälter einzuleiten.

In dem Behälter 10 befinden sich zwei Kühlvorrichtungen 15,16. Die Kühlvorrichtung 15 umgibt den Arbeitsraum 13 und die zweite Kühlvorrichtung 16 wird von dem Arbeitsraum umschlossen.

Die Kühlvorrichtung besteht aus einem ersten Kühlelement 15a in Form einer schraubenförmigen Rohrwendel und einem zweiten Kühlelemente 15b in Form einer schraubenförmigen Rohrwendel. Die Windungen der beiden schraubenförmigen Kühlelemente 15a,15b liegen auf demselben gedachten Zylindermantel, so dass die Kühlvorrichtung 15 insgesamt aus einer einlagigen zweigängigen Schraube besteht. Die Windungen des ersten und des zweiten Kühlelements 15a,15b sind mit gegenseitigen Abständen angeordnet und zwar so, dass die Windungen beider Kühlelemente sich gegenseitig abwechseln. Die Windungen sind daher miteinander verschachtelt. Bei drei Kühlelementen würden die Windungen in der Reihenfolge a,b,c,a,b ... auftreten. In der Zeichnung sind zur besseren Unterscheidbarkeit die Windungen des ersten Kühlelements 15a mit größerer Strichstärke gezeichnet als diejenigen des zweiten Kühlelements.

Das Kühlelement 15a weist einen Zulauf Z1 und einen Ablauf A1 auf. Das Kühlelement 15b weist einen Zulauf Z2 und einen Ablauf A2 auf. Beide Kühlelemente werden unabhängig voneinander von Wasser durchströmt. Dieses ist gegenüber der Temperatur, die das Werkstück 14 bei der Plasmabearbeitung einnimmt (ca. 200 bis 800°C) kalt. Daher überträgt das Werkstück 14 Strahlungswärme auf die Kühlelemente der Kühlvorrichtung 15. Die Kühlelemente sind einzeln einschaltbar und abschaltbar. Im eingeschalteten Zustand ist das Kühlelement von Kühlflüssigkeit durchflossen. Im abgeschalteten Zustand bleibt die Kühlflüssigkeit stehen und erwärmt sich oder wird entfernt. Im Falle eines großen Kühlbedarfs werden beide Kühlelemente 15a,15b eingeschaltet und im Falle eines geringeren Kühlbedarfs wird nur eines der Kühlelemente eingeschaltet. In jedem Fall wird durch das eingeschaltete Kühlelement die dem Werkstück 14 zugewandte Kühlfläche vergrößert. Die Erfindung beruht auf dem Vergrößern und Verkleinern dieser Kühlfläche.

Die innere Kühlvorrichtung 16 weist ein erstes Kühlelement 16a in Form einer schraubenförmigen Rohrwendel und ein zweites Kühlelement 16b in Form einer schraubenförmigen Rohrwendel auf. Beide Rohrwendeln sind ebenfalls miteinander verschachtelt, d.h. ihre Windungen wechseln einander ab und sie liegen auf einer gemeinsamen Zylinderfläche. Zwischen den Windungen bestehen Abstände, die größer sind als der Außendurchmesser des Rohres. Ebenfalls sind zur Verdeutlichung die Rohre des ersten Kühlelements 16a in dickerer Strichstärke gezeichnet als diejenigen des zweiten Kühlelements 16b.

Der Zulauf des ersten Kühlelements 16a ist mit Z3 und der Ablauf mit A3 bezeichnet. Bei dem zweiten Kühlelement 16b ist der Zulauf mit Z4 und der Ablauf mit A4 bezeichnet.

Das Kühlelement 15a ist mit der Masseelektrode der Spannungsquelle 18 verbunden, so dass dieses Kühlelement als Elektrode für die Plasmaerzeugung mitbenutzt wird. Ebenso kann auch jedes andere Kühlelement mit der Masseelektrode verbunden sein.

Das obere und das untere Ende des Arbeitsraumes 13 sind von Kühlelementen frei, da für diese Enden eine größere Strahlungsempfangsfläche der Behälterwand zur Aufnahme der Wärmestrahlung zur Verfügung steht.

Der Plasmareaktor wird zunächst in einer Plasma-Betriebsart betrieben, in der der Behälter 10 evakuiert ist und das Werkstück unter Plasmaerzeugung bearbeitet wird. Dabei wird die Kühlung in der Weise vorgenommen, dass die benötigte Anzahl von Kühlelementen 15a,15b,16a,16b eingeschaltet wird, wobei die eingeschalteten Kühlelemente von Kühlflüssigkeit durchströmt werden. Dadurch wird die wärmeaufnehmende Kühlfläche entsprechend der Anzahl der eingeschalteten Kühlelemente bemessen.

Im Anschluss an die Plasma-Betriebsart erfolgt eine Abkühlungs-Betriebsart, bei der ein Inertgas, z.B. Stickstoff, in den Behälter 10 eingelassen wird. Dabei ist das Radialgebläse 17 eingeschaltet, so dass das Gas in dem Behälter zirkulieren kann. Dabei strömt das Gas zwischen den Windungen der Kühlelemente hindurch und an der Werkstückoberfläche entlang. Die eingezeichneten Pfeile 19 verdeutlichen den Gasstrom. Das Inertgas strömt zunächst von dem Radialgebläse 17 nach außen und an der Behälterwand entlang. Es strömt dann radial durch die Kühlvorrichtung 15, das Werkstück 14 und die Kühlvorrichtung 16 hindurch, um dann im Zentrum des Behälters wieder vom Gebläse 17 angesaugt zu werden.

Das Zuschalten bzw. Abschalten einzelner Kühlelemente kann durch Wärmesensoren erfolgen, die die Temperatur an bestimmten Stellen des Innenraums des Reaktors feststellen.

## Patentansprüche

1. Plasmareaktor mit einem mit einer Vakuumpumpe verbindbaren vakuumdichten Behälter (10), der einen Arbeitsraum (13) zur Aufnahme von Werkstücken (14) enthält, einer Spannungsquelle (18) zum Anlegen einer Spannung an das Werkstück (14) und mindestens einer in dem Behälter (10) angeordneten Kühlvorrichtung (15,16) zum Abführen von Strahlungswärme, die aus mindestens zwei Kühlelementen (15a,15b;16a,16b) besteht,
**dadurch gekennzeichnet,**
**dass** mindestens zwei Kühlelemente (15a,15b;16a,16b) Kühlschlangen sind, deren Windungen miteinander verschachtelt sind und die zur Vergrößerung oder Verkleinerung der wirksamen Kühlfläche einzeln ein- und ausschaltbar sind.

2. Plasmareaktor nach Anspruch 1, **dadurch gekennzeichnet, dass** die Kühlelemente (15a,15b;16a,16b) in abwechselnder Folge angeordnet sind.

3. Plasmareaktor nach Anspruch 1 oder 2, **dadurch gekennzeichnet, dass** die Kühlelemente (15a,15b;16a,16b) sich über mindestens dreiviertel der Höhe des Arbeitsraumes (13) erstrecken und horizontale Gasströmung durchlassen.

4. Plasmareaktor nach einem der Ansprüche 1-3, **dadurch gekennzeichnet, dass** mindestens zwei Kühlelemente (15a,15b) ringförmig um den ringförmigen Arbeitsraum (13) angeordnet sind.

5. Plasmareaktor nach einem der Ansprüche 1-4, **dadurch gekennzeichnet, dass** mindestens zwei Kühlelemente (16a,16b) von dem Arbeitsraum (13) umgeben sind.

6. Plasmareaktor nach einem der Ansprüche 1-5, **dadurch gekennzeichnet, dass** mindestens ein Kühlelement (15a) als Elektrode an die Spannungsquelle (18) angeschlossen ist.

7. Plasmareaktor nach einem der Ansprüche 1-6, **dadurch gekennzeichnet, dass** die Kühlelemente sich über den mittleren Bereich der Höhe des Arbeitsraumes (13) erstrecken und die Enden unbeeinflusst lassen.

## Claims

1. A plasma reactor, comprising a vacuum-tight container (10) adapted to be connected with a vacuum pump and including a process room (13) for receiving works (14), a voltage source (18) for applying a voltage to the work (14), and at least one cooling device (15,16) arranged in the container (10) and consisting of at least two cooling elements (15a,15b;16a,16b), for dissipating radiation heat,
**characterized in**
**that** at least two cooling elements (15a,15b;16a,16b) are cooling coils the windings of which are interlaced with each other and which are adapted to be individually switched on and off for enlarging or reducing the effective cooling surface.

2. The plasma reactor of claim 1, **characterized in that** the cooling elements (15a,15b;16a,16b) are arranged in alternating succession.

3. The plasma reactor of claim 1 or 2, **characterized in that** the cooling elements (15a,15b;16a,16b) extend over at least three quarters of the height of the process room (13) and let through a horizontal gas flow.

4. The plasma reactor of one of claims 1 to 3, **characterized in that** at least two cooling elements (15a,15b) are arranged about the annular process room (13) in an annular manner.

5. The plasma reactor of one of claims 1 to 4, **characterized in that** at least two cooling elements (16a,16b) are surrounded by the process room (13).

6. The plasma reactor of one of claims 1 to 5, **characterized in that** at least one cooling element (15a) is connected to the voltage source (18) as an electrode.

7. The plasma reactor of one of claims 1 to 6, **characterized in that** the cooling elements extend over the central portion of the height of the process room (13) and leave the ends uninfluenced.

## Revendications

1. Réacteur à plasma comprenant un récipient (10) étanche au vide pouvant être raccordé à une pompe à vide, qui contient un espace de travail (13) pour loger des pièces à usiner (14), une source de tension (18) pour appliquer une tension sur la pièce à usiner (14), et au moins un dispositif de refroidissement (15, 16) disposé dans le récipient (10) pour dissiper la chaleur rayonnante, et composé d'au moins deux éléments de refroidissement (15a, 15b, 16a, 16b), **caractérisé en ce qu'**au moins deux éléments de refroidissement (15a, 15b, 16a, 16b) sont des serpentins de réfrigération, dont les spires sont entrelacées et qui peuvent être mis individuellement en et hors service pour augmenter ou diminuer la surface de refroidissement effective.

2. Réacteur à plasma selon la revendication 1, **caractérisé en ce que** les éléments de refroidissement (15a, 15b, 16a, 16b) sont disposés dans une séquence alternante.

3. Réacteur à plasma selon la revendication 1 ou 2, **caractérisé en ce que** les éléments de refroidissement (15a, 15b, 16a, 16b) s'étendent sur au moins trois quarts de la hauteur de l'espace de travail (13) et laissent passer le courant de gaz horizontalement.

4. Réacteur à plasma selon l'une quelconque des revendications 1 à 3, **caractérisé en ce qu'**au moins deux éléments de refroidissement (15a, 15b) sont disposés de manière circulaire autour de l'espace de travail (13) circulaire.

5. Réacteur à plasma selon l'une quelconque des revendications 1 à 4, **caractérisé en ce qu'**au moins deux éléments de refroidissement (16a, 16b) sont entourés par l'espace de travail (13).

6. Réacteur à plasma selon l'une quelconque des revendications 1 à 5, **caractérisé en ce qu'**au moins un élément de refroidissement (15a) est raccordé à la source de tension (18) comme une électrode.

7. Réacteur à plasma selon l'une quelconque des revendications 1 à 6, **caractérisé en ce que** les éléments de refroidissement s'étendent sur la partie médiane de la hauteur de l'espace de travail (13) et n'influencent pas les extrémités.
